Europäisches Patentamt

European Patent Office

Office européen des brevets

(11) Veröffentlichungsnummer : **0 080 523**
**B1**

(12) # EUROPÄISCHE PATENTSCHRIFT

(45) Veröffentlichungstag der Patentschrift :
01.10.86

(51) Int. Cl.⁴ : **H 01 L 21/82, H 01 L 27/04, H 01 L 21/265**

(21) Anmeldenummer : 01109995.1

(22) Anmeldetag : 28.11.81

(54) **Verfahren zum Herstellen einer monolithisch integrierten Schaltung mit mindestens einem Paar von komplementären Feldeffekttransistoren und mindestens einem Bipolartransistor.**

(43) Veröffentlichungstag der Anmeldung :
08.06.83 Patentblatt 83/23

(45) Bekanntmachung des Hinweises auf die Patenterteilung : 01.10.86 Patentblatt 86/40

(84) Benannte Vertragsstaaten :
DE FR GB IT NL

(56) Entgegenhaltungen :
DE-A- 2 728 845
DE-A- 2 753 704
GB-A- 1 362 345
SOLID STATE DEVICES, 1980 London, New York B. HOEFFLINGER et al. "New CMOS Technologies" Seiten 114 bis 117
NTG-FACHBERICHTE, Band 77, März 1981 Berlin J. SOLO DE ZALDIVAR "CMOS-Prozess mit selbstjustierenden Kontakten" Seiten 22 bis 29

(73) Patentinhaber : Deutsche ITT Industries GmbH
Hans-Bunte-Strasse 19 Postfach 840
D-7800 Freiburg (DE)
DE
ITT INDUSTRIES INC.
320 Park Avenue
New York, NY 10022 (US)
FR GB IT NL

(72) Erfinder : Gahle, H. Jürgen, Dr. Ing.
Panoramastrasse 13
D-7830 Emmendingen (DE)

(74) Vertreter : Morstadt, Volker, Dipl.-Ing.
c/o Deutsche ITT Industries GmbH Patent/Lizenzabteilung Postfach 840 Hans-Bunte-Strasse 19
D-7800 Freiburg/Brsg. (DE)

**Beschreibung**

Aus dem Aufsatz « New CMOS technologies » von B. Hoeffinger und G. Zimmer in der Veröffentlichung « Solid State Devices » 1980, Herausgeber J. E. Carroll, Seiten 114 bis 117 ist ein Verfahren zum Herstellen einer monolithisch integrierten Schaltung mit mindestens einem Paar von komplementären Si-Gate-Feldeffekttransistoren und mindestens einem planaren NPN-Bipolartransistor bekannt. Bei diesem Verfahren wird in der einen Oberflächenseite eines p-leitenden plattenförmigen Substratkörpers sowohl für den NPN-Bipolartransistor als auch für den P-Kanal-Feldeffekttransistor je eine Substratzone erzeugt, welche durch je eine PN-Übergangsfläche gleichstrommäßig gegen den Substratkörper elektrisch getrennt ist. Auf dieser Oberflächenseite des Substratkörpers wird nach der Erzeugung der Substratzonen eine Dickoxidschicht mit Durchbrüchen gebildet, durch die unter Verwendung einer gegen Ionenimplantation wirksamen Maskierung zur Einstellung der Schwellspannungen der Transistoren und der Feldschwellspannung zwischen den Transistoren örtlich Ionen implantiert werden. Zusätzlich zu den bei der konventionellen Si-Gate-CMOS-Technologie angewendeten Prozessen wird ein zusätzlicher Maskierungs- und Implantationsprozeß zur Implantation der Dotierungen der Basiszone des Bipolartransistors durchgeführt. Diese Implantation erfolgt durch eine Dünnoxidschicht, welche gleichzeitig mit den Dünnoxidschichten in den Bereichen der Feldeffekttransistoren erzeugt wird. Unter Anwendung zweier maskierter Ionenimplantationsprozesse werden entsprechend der bekannten Si-Gate-CMOS-Technologie das eine Mal die Dotierungen der Zonen des N-Kanal-Feldeffekttransistors und das andere Mal die Dotierungen der Zonen des P-Kanal-Transistors in die Halbleiteroberfläche eingebracht, wobei die aus einer n-dotierten Elektrodenmaterialschicht herausgeätzten Gateelektroden als Maske verwendet werden. Gleichzeitig mit der Herausätzung der Gateelektroden wird die Emitterzone des Bipolartransistors auf der freigelegten Oberfläche des Basiszone ausgebildet. Aus dieser Emitterzone wird bei einem folgenden Hochtemperaturprozeß die Emitterzone in die Basiszone diffundiert.

Dieses bekannte Verfahren hat zunächst einmal im Hinblick auf den Bipolartransistor den Nachteil eines kompensierten Emitters, d. h. eines Dotierungen der Basiszone im erheblichen Umfange enthaltenden Emitters. Die widersprüchlichen Forderungen nach einem niedrigen Basiswiderstand und flachen Implantationen, was im Hinblick auf hohe Geschwindigkeiten erforderlich ist, können beim bekannten Verfahren nicht erfüllt werden.

Ein wesentlicher Nachteil des bekannten Verfahrens ist aber der gegenüber den Feldeffekttransistoren erheblich erhöhte Platzbedarf des Bipolartransistors. So benötigt dieser ohne Berücksichtigung des Platzbedarfs für diese Substratzone eine mehr als doppelt so große Fläche als ein Feldeffekttransistor, was vor allem durch die notwendigen Justiertoleranzen bedingt ist. Es ist nämlich sowohl die Justierung der Basiszone zum Kollektorkontakt als auch die Justierung der Emitterzone zur Basis kritisch.

Aufgabe der Erfindung ist daher die Angabe eines gegenüber dem bekannten CMOS-Verfahren abgewandelten Verfahrens, welches die Herstellung eines integrierten Bipolartransistors unter Verwendung möglichst selbstjustierender und/oder unkritischer prozesse erlaubt und daher auch hinsichtlich des Platzbedarfs des Bipolartransistors eine wesentliche Ersparnis erbringt.

Die Erfindung betrifft somit ein Verfahren gemäß dem Oberbegriff des Anspruchs 1, wobei auch an die Verwendung von n-dotiertem Elektrodenmaterial, beispielsweise an ein n-dotiertes Silicid, gedacht ist.

Die oben genannte Aufgabe wird erfindungsgemäß durch die im kennzeichnenden Teil des Anspruchs 1 angegebenen Verfahrensmaßnahmen gelöst.

Das Verfahren nach der Erfindung macht also von der Einfachheit des bekannten Verfahrens Gebrauch, wobei die Prozesse des bekannten Verfahrens hinsichtlich der Herstellung des Bipolartransistors in besonderer Weise verwendet werden. Da die Prozesse hinsichtlich der Herstellung der Feldeffekttransistoren unverändert bleiben, sind auch keine Änderungen der elektrischen Eigenschaften dieser zu erwarten.

Die größte Platzersparnis ergibt sich, wenn beim Verfahren nach der Erfindung der Durchbruch des Bipolartransistors von einer streifenförmigen dünnen Oxidschicht geteilt wird und die freiliegenden Teile der Halbleiteroberfläche, vom Oxidschichtstreifen betrachtet, einerseits vom Emitterzonenbereich und andererseits vom Kollektorkontaktzonenbereich bis zum Rande des Durchbruchs in der Dickoxidschicht ausgefüllt werden.

Unter Verwendung eines unkritischen Maskierungsprozesses werden anschließend Ionen in den freiliegenden Emitterbereich bei einer solchen Beschleunigungsenergie implantiert, daß die Dünnoxidschicht 9 durchdrungen wird und sich unter dem Bereich der noch zu erzeugenden Emitterzone im Halbleiterkörper ein Dotierungsbereich von Verunreinigungen der zu erzeugenden Basiszone ausbildet, aus dem bei einem später erfolgenden Hochtemperaturprozeß ein Basisbereich entsteht, der mit dem seitlich sich erstreckenden Basisbereich an der Halbleiteroberfläche zusammenhängt. Vorzugsweise werden sämtliche Durchbrüche in der Dickoxidschicht rechteckig ausgebildet.

Ein weiteres wesentliches Merkmal des Verfahrens nach der Erfindung beruht auf der Verwendung einer n-dotierten Elektrodenmaterialschicht, aus der sowohl die Gateelektroden der Feldeffekttransistoren als auch die Emitterelektrode und die Kollektorelektrode des Bipolartransistors herausgeätzt werden, wovon die beiden zuletzt genannten als Diffusionsquellen verwendet werden.

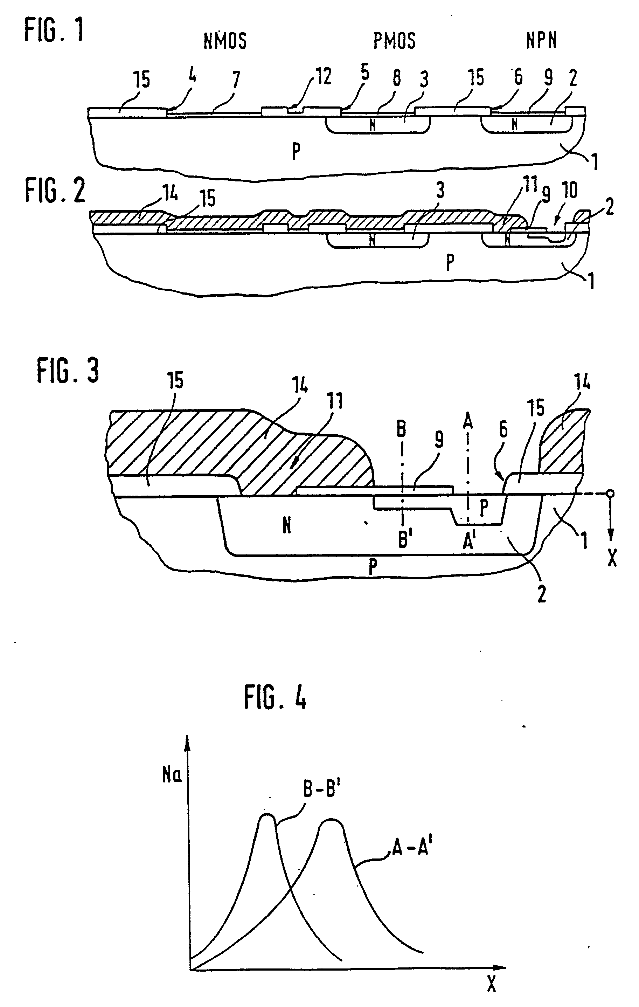

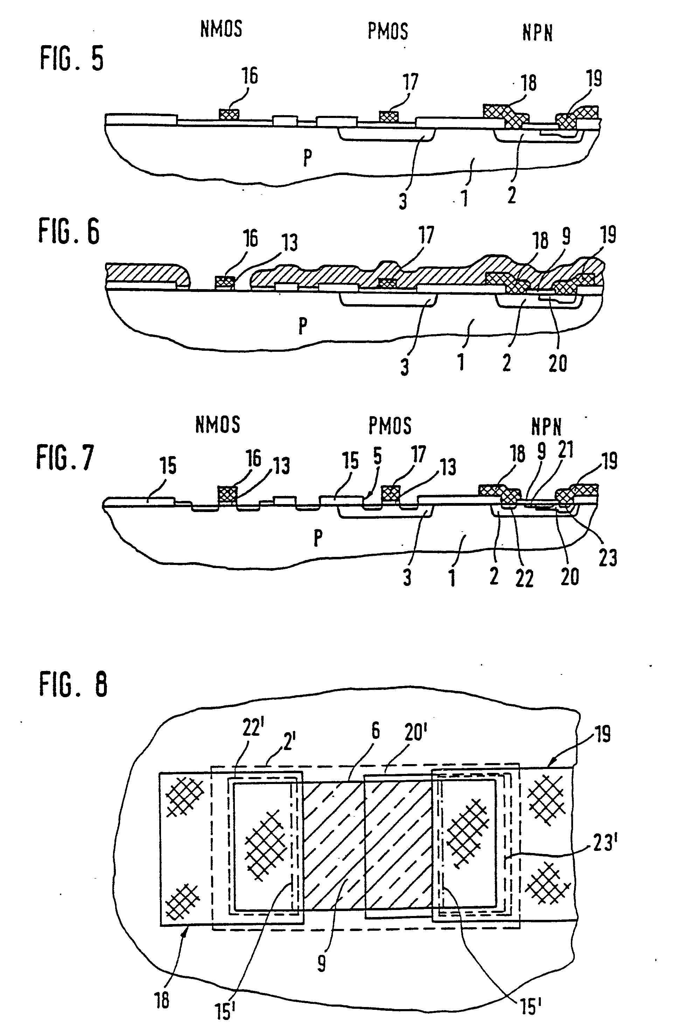

Das Verfahren nach der Erfindung wird im folgenden an einem bevorzugten Ausführungsbeispiel anhand der Zeichnung erläutert,

deren Figur 1 und 2 zur Veranschaulichung aufeinanderfolgender Prozesse des Verfahrens nach der Erfindung dienen,

deren Figur 3 den NPN-Bipolartransistors der monolithisch integrierten Schaltung zeigt,

deren Figur 4 schematisch den Konzentrationsverlauf der Verunreinigungen entlang den Schnittlinien B-B' und A-A' der Fig. 3 veranschaulichen,

deren Figuren 5 bis 7 zur Erläuterung von weiteren aufeinanderfolgenden Prozessen des Verfahrens nach der Erfindung dienen und

deren Figur 8 die Aufsicht auf den Bipolartransistor der Fig. 7 zeigt.

Beim Verfahren nach der Erfindung wird ein plattenförmiger Substratkörper 1 aus p-dotiertem Silizium verwendet, in dessen eine Oberflächenseite für den NPN-Bipolartransistor in bekannter Weise eine erste Substratzone 2 und für den P-Kanal-Feldeffekttransistor eine zweite Substratzone 3 erzeugt wird. Zum Einbringen des Dotierungsmaterials in die Halbleiteroberflächenseite wird vorzugsweise ein maskierter Ionenimplantationsprozeß verwendet.

Nach Entfernung der zu diesem Zweck erforderlichen Maskierungsschicht wird auf der Oberflächenseite eine Dickoxidschicht 15 durch thermische Oxidation erzeugt, wobei entweder die Bereiche der Substratzonen 2 und 5 und der Bereich des N-Kanal-Feldeffekttransistors gegen eine Oxidation des Halbleitermaterials mittels einer Oxidationsmaskierungsschicht, beispielsweise aus Siliziumnitrid, maskiert wird oder eine einheitlich dicke Dickoxidschicht 15 durch nichtmaskierte thermische Oxidation erzeugt wird. Zur vereinfachten Darstellung bezieht sich die Fig. 1 auf den letzteren Fall. Im ersteren Fall werden Dickoxidschichtteile erhalten, welche zwischen den Transistoren in den Halbleiterkörper versenkt sind. Entsprechend dem bekannten Verfahren der eingangs erwähnten Literaturstelle wird nun ein Gateoxidationsprozeß durchgeführt, bei dem innerhalb der Durchbrüche 4, 5 und 6 die Durchbrüche schließende Dünnoxidschichten 7, 8 und 9 gebildet werden und die Substratzonen 2 und 3 durch Aktivierung und Diffusion der Dotierungen entstehen, wie die Fig. 1 veranschaulicht.

Beim Verfahren nach der Erfindung wird nunmehr die Halbleiteroberfläche innerhalb des Emitterzonenbereichs 10 und des Kollektorkontaktierungsbereichs 11 des Bipolartransistors freigelegt, was unter Anwendung eines photolithographischen Ätzprozesses erfolgt. Danach wird die Ionenmaskierungsschicht 14 gemäß der Fig. 2 aufgebracht, welche den Emitterzonenbereich 10 und einen daran angrenzenden Teil unter der Dünnoxidschicht 9 des Bipolartransistors unbedeckt läßt. Es erfolgt nun eine Ionenimplantation von Verunreinigungen des Leitungstyps der Basiszone des Bipolartransistors bei einer solchen Beschleunigungsspannung, daß die Dünnoxidschicht 9 zwar durchdrungen wird, die Ionen aber unter diesem freiliegenden Teil der Dünnoxidschicht 9 bereits an der Oberfläche des Halbleiterkörpers abgebremst werden.

In der Fig. 3 ist der Teil des Bipolartransistors vergrößert herausgezeichnet. In dieser Fig. 3 sind senkrecht zur Halbleiteroberfläche ein Schnitt B-B' durch den freiliegenden Teil der Dünnoxidschicht 9 liegenden Basiszonenteil und entlang der Schnittlinie A-A' durch denjenigen Basisteil gelegt, der später unter der Emitterzone zu liegen kommt.

Die Fig. 4 zeigt schematisch die Dotierungskonzentration $N_a$ in Abhängigkeit von der Tiefe X entlang dieser beiden Schnittlinien. Es zeigt sich, daß der Teil der Basiszone unterhalb der noch zu erzeugenden Emitterzone relativ tief unter der Halbleiteroberfläche verlegt worden ist, so daß von einer « vergrabenen » Basiszone gesprochen werden kann. Dies hat die Vorteile eines nichtkompensierten Emitters, d. h. eines Emitters, der nur relativ wenige Atome der Basiszone enthält, die überkompensiert werden müssen. Die Menge der implantierten Verunreinigungen der Basiszone entspricht direkt der gewünschten Stromverstärkung.

Beim Ausführungsbeispiel des Verfahrens nach der Erfindung wird der Durchbruch 6 in der Dickoxidschicht 15 rechteckig ausgebildet und von einer streifenförmigen Dünnoxidschicht 9 geteilt, welche zusammen mit dem Emitterzonenbereich 10 und dem Kollektorkontaktzonenbereich 11 den Durchbruch 6 ausfüllt. Dies hat den Vorteil einer unkritischen Justierung in der Richtung der Längserstreckung der Dünnoxidschicht 9.

Nach der Implantation der Verunreinigungen der Basiszone 20 wird die Maskierungsschicht 14 entfernt und auf die erwähnte Oberflächenseite des Substratkörpers 1, welche teilweise von der Dickoxidschicht 15 und teilweise von den Dünnoxidschichten 7, 8 und 9 bedeckt ist, eine n-dotierte Elektrodenmaterialschicht aufgebracht, aus der unter Verwendung eines photolithographischen Ätzprozesses die Gateelektroden 16 und 17 der Feldeffekttransistoren, die Emitterelektrode 19 und die Kollektorelektrode 18 des Bipolartransistors herausgeätzt werden. Vorzugsweise wird eine Elektrodenmaterialschicht aus n-dotiertem Silizium aufgebracht.

Danach erfolgt unter Anwendung zweier maskierter Ionenimplantationsprozesse nach Entfernung der Photolackschichten und Freilegung der Halbleiteroberfläche neben den Gateelektroden 16 und 17 in der bei der Si-Gate-Technologie bekannten Weise das eine Mal die Implantation der Dotierungen der Zonen des N-Kanal-Feldeffekttransistors und das andere Mal die der Dotierungen der Zonen des P-Kanal-Feldeffekttransistors. Abweichend von dem eingangs erwähnten Verfahren wird jedoch bei dem maskierten Implantationsprozeß der Dotierungen der Zonen des P-Kanal-Feldeffekttransistors die Implantation der Dotierungen einer Basiskontaktierungszone 21 in die Halbleiteroberfläche zwischen der Emitterelektrode 19 und der Kollektorzone 18 durchgeführt. Dabei werden die Emitterelektrode 19 und die Kollektorelektrode 18 als Maske für die Implantation der Dotierungen der Basiskontaktierungszone 21 gemäß der Fig. 7 verwendet. Auch dieser Maskierungsprozeß ist hinsichtlich einer genauen Justierung der Implantationsmaskierung unkritisch, da die Ränder der Maskierung durch die Ränder der Dickoxidschicht 15 und die der Emitterelektrode 19 und der Kollektorelektrode 18 gegeben ist. Es ist daher beinahe ausgeschlossen, daß die Basiskontaktierungszone 21 die Basiszone 20 verfehlt.

Besondere Sorgfalt ist jedoch bei der Justierung der Ätzmaske zum Herstellen der Elektroden 16, 17, 18 und 19 bezüglich der Ränder der Dünnoxidschicht 9 erforderlich. Durch die Überlappung der Kollektorelektrode 18 über die Dünnoxidschicht 9 wird nämlich die Kollektor-Basis-Abbruchspannung beeinflußt. Außerdem ist ein gewisser Mindestabstand der Basiskontaktierungszone 21 von der Emitterzone 23 an der Halbleiteroberfläche erforderlich.

Im Interesse einer Platzersparnis sollte auch bei den Feldeffekttransistoren so verfahren werden, wie es bei dem P-Kanal-Feldeffekttransistor der Fig. 7 ersichtlich ist. Bei diesem Feldeffekttransistor sind nämlich die Ränder der Zonen abgesehen von dem von der Elektrode 17 begrenzten Ränder von den Rändern der Öffnung 5 in der Dickoxidschicht 15 bestimmt. Ähnlich wie bei dem Bipolartransistor sollten die Durchbrüche 4 und 5 in der Dünnoxidschicht 10 von je einer streifenförmigen Dünnoxidschicht 13 geteilt werden, welche als Gateoxidschicht verwendet wird. Dies hat den Vorteil einer unkritischen Justierung in der Richtung der Längserstreckung der Dünnoxidschichten 13. Die Kontakte an den Zonen und Elektroden sowie die verbindenden Leiterbahnen werden schließlich in bekannter Weise hergestellt.

Eine weitere Verminderung der benötigten Bauelementfläche erhält man durch Anwendung von Prozessen mit selbstjustierenden Elektroden, wobei die Gateelektroden 16 und 17 oberflächlich oxidiert werden, so daß eine gewissen Überlappung mit den Elektroden an den Zonen der Feldeffekttransistoren in Kauf genommen wird. In diesem Zusammenhang wird auf « NTG-Fachberichte » Bd. 77, Seiten 22 bis 29 verwiesen. Durch diese Technik mit selbstjustierenden Kontakten wird zwar Bauelementfläche gespart. Es sind aber erheblich höhere Kapazitäten zwischen den Gateelektroden und den im allgemeinen aus Aluminium bestehenden Kontakten an den Zonen der Feldeffekttransistoren in Kauf zu nehmen. Außerdem muß wegen der aus Justiergründen notwendigen Überlappung die Gatelänge der Feldeffekttransistoren vergrößert werden, was sich ebenfalls auf die Frequenzeigenschaften negativ auswirkt. Die Anwendung von solchen selbstjustierenden Kontakten ist also auf relativ langsame Schaltungen begrenzt.

Die Fig. 8 zeigt nun in Aufsicht einen vergrößerten Ausschnitt der monolithisch integrierten Festkörperschaltung gemäß der Fig. 7 mit dem Bipolartransistor. Der Pfeil 6 weist auf den Rand der Öffnung in der Dickoxidschicht 15. Die PN-Übergangsfläche der Kollektorzone 2 tritt entlang der gestrichelten Linie 2' an die Halbleiteroberfläche, während die n-dotierten Elektroden 19 und 18 durch die Öffnungen 15' in Kontakt mit der Halbleiteroberfläche stehen. Dementsprechend ist die Überlappung der Elektroden 18 und 19 über die Dünnoxidschicht 9 gegeben durch den Abstand der strichpunktierten Linie 15' zu dem durchgezogenen Rand der Elektroden 18 und 19. Die PN-Übergangsflächen der Kollektorkontaktierungszone 22 und der Emiterzone 23 treten bei den gestrichelten Linien 22' bzw. 23' an die Halbleiteroberfläche. Bei dem zur Diffusion der PN-Übergänge der Emitterzone 23 und der Kollektorkontaktierungszone 22 angewendeten Hochtemperaturprozeß werden die Dotierungen der Zonen der Feldeffekttransistoren und die der Basiszone 20 wie die der Basiskontaktierungszone 21 der Bipolartransistors aktiviert und in den Halbleiterkörper eindiffundiert. Der Platzbedarf des NPN-Planartransistors ist lediglich 15 % größer als der des PMOS-Feldeffekttransistors.

Ein weiterer wesentlicher Vorteil des Verfahrens nach der Erfindung besteht darin, daß ohne zusätzliche Verfahrensschritte auch andere Transistorkomponenten mitintegriert werden können. Einen lateralen PNP-Transistor erhält man durch Verwendung einer PMOS-Feldeffekttransistorstruktur, indem die Substratzone als Basiszone benutzt wird. Der Anschluß an die Substratzone 3 wird mittels des n-dotierten Elektrodenmaterials, vorzugsweise mittels n-dotiertem Poly-Silizium, erzeugt. Vertikale Substrat-PNP-Transistoren ergeben sich aus dem NPN-Transistor durch Weglassen der Emitterzone. Bei dem Verfahren nach der Erfindung können also auch komplementäre bipolare Transistoren ohne weiteres zur Verfügung gestellt werden.

Bei dem Verfahren nach der Erfindung können die Substratzonen 2 und 3 auch aus einer Epitaxialschicht des einen Leitungstyps auf einen Substratkörper 1 des anderen Leitungstyps mittels einer elektrischen Trennung durch eine die Epitaxialschicht durchdringende Oxidation der Diffusion von Dotierungen des Substratkörpers 1 abgegrenzt werden.

**Patentansprüche**

1. Verfahren zum Herstellen einer monolithisch integrierten Schaltung mit mindestens einem Paar von komplementären Feldeffekttransistoren, deren Gate-Elektroden aus einem n-dotierten Elektrodenmaterial bestehen, und mindestens einem planaren NPN-Bipolartransistor, bei welchem Verfahren

in die eine Oberflächenseite eines p-leitenden plattenförmigen Substratkörpers (1) für den NPN-Bipolartransistor eine erste Substratzone (2) und für den P-Kanal-Feldeffekttransistor eine zweite Substratzone (3) erzeugt werden,

dann auf der freigelegten Oberflächenseite eine Dickoxidschicht (15) erzeugt wird, in welcher innerhalb der Bereiche der Substratzonen (2, 3) und des Bereiches des N-Kanal-Feldeffekttransistors Durchbrüche (4, 5, 6) erzeugt werden, welche mittels Dünnoxidschichten (7, 8, 9) während eines Gateoxidationsprozesses geschlossen werden,

anschließend unter Verwendung einer Ionenmaskierung durch Teile der Dünnoxidschicht (9) des Bipolartransistors Dotierungen vom Substratleitungstyp bei einer solchen Beschleunigungsspannung implantiert werden, daß die Dünnoxidschicht (9) durchdrungen wird,

dann auf die Oberflächenseite eine n-dotierte Elektrodenmaterialschicht aufgebracht wird, aus der die Gateelektroden (16, 17) der Feldeffekttransistoren und die Emitterelektrode (19) des Bipolartransistors herausgeätzt werden und

anschließend unter Anwendung zweier maskierter Ionenimplantationsprozesse nach Freilegung der Halbleiteroberfläche neben den Gateelektroden (16, 17) das eine Mal die Dotierungen der Zonen des N-Kanal-Feldeffekttransistors und das andere Mal die Dotierungen der Zonen des P-Kanal-Feldeffekttransistors vor einer Aktivierung der Dotierungen in die Halbleiteroberfläche eingebracht werden, dadurch gekennzeichnet

daß nach dem Gateoxidationsprozess die Halbleiteroberfläche innerhalb des Emitterzonenbereichs (10) und des Kollektorkontaktierungszonenbereichs (11) des Bipolartransistors freigelegt wird,

daß Dotierungen des Substratleitungstyps unter Anwendung einer Ionenmaskierung in die freiliegende Halbleiteroberfläche des Emitterzonenbereichs (10) und eines daran angrenzenden Teil unter der Dünnoxidschicht (9) des Bipolartransistors implantiert werden,

daß dann aus der über die Oberflächenseite aufgebrachten n-dotierten Elektrodenmaterialschicht die Gateelektroden (16, 17) der Feldeffekttransistoren, die Emitterelektrode (19) des Bipolartransistors und die Kollektorelektrode (18) des Bipolartransistors herausgeätzt werden,

daß anschließend bei dem maskierten Implantationsprozess der Dotierungen der Zonen des P-Kanal-Feldeffekttransistors die Dotierungen einer Basiskontaktierungszone (21) in die Halbleiteroberfläche zwischen der Emitterelektrode (19) und der Kollektorelektrode (18) in die Halbleiteroberfläche eingebracht werden und

daß schließlich ein Hochtemperaturprozess zur Anwendung kommt, bei dem die implantierten Ionen aktiviert, die Emitterzone (23) aus der Emitterelektrode (19) und die Kollektorkontaktierungszone (22) aus der Kollektorelektrode (18) diffundiert werden.

2. Verfahren nach Anspruch 1, dadurch gekennzeichnet, daß der Emitterzonenbereich (10) und der Kollektorkontaktzonenbereich (11) einen Durchbruch (6) innerhalb des Bereiches der Substratzone (2) des Bipolartransistors beiderseits einer den Druchbruch (6) teilenden streifenförmigen Dünnoxidschicht (9) zusammen mit der Dünnoxidschicht (9) ansfüllt.

3. Verfahren nach Anspruch 1 oder 2, dadurch gekennzeichnet, daß der Durchbruch (6) rechteckförmig ausgebildet wird.

4. Verfahren nach einem der Ansprüche 1 bis 3, dadurch gekennzeichnet, daß der Durchbruch (6) von einer streifenförmigen Dünnoxidschicht (9) geteilt wird, welche über die gesamte Länge des Randes angrenzend an die Kollektorelektrode (18) von dieser überlappt wird.

5. Verfahren nach einem der Ansprüche 1 bis 4, dadurch gekennzeichnet, daß die Durchbrüche (4, 5) der Feldeffekttransistoren in der Dickoxidschicht (10) von je einer streifenförmigen Dünnoxidschicht (13) geteilt werden, welche als Gateoxidschichter, verwendet werden.

## Claims

1. Method of making a monolithic integrated circuit comprising at least one pair of complementary fieldeffect transistors whose gate electrodes are made of an n-type material, and at least one NPN bipolar planar transistor,

wherein in one surface side of a p-type wafer used as a substrate (1), a first substrate region (2) and a second substrate region (3) are formed for the NPN bipolar transistor and the P-channel field-effect transistor, respectively ;

wherein the exposed surface is then provided with a thick oxide layer (15) in which openings (4, 5, 6) are formed in the areas of the substrate regions (2, 3) and of the N-channel field-effect transistor which are closed by means of thin oxide layers (7, 8, 9) during a gate oxidation process ;

wherein, using a mask against implanted ions, impurities of the conductivity type of the substrate are then implanted through portions of the thin oxide layer (9) of the bipolar transistor at such an accelerating voltage as to penetrate the thin oxide layer (9) ;

wherein an n-type electrode material layer is then deposited from which unwanted portions are etched away to form the gate electrodes (16, 17) of the field-effect transistors and the emitter electrode (19) of the bipolar transistor, and

wherein, in two masked ion-implantation steps after exposure of the semiconductor surface beside the gate electrodes (16, 17) first the impurities of the regions of the N-channel field-effect transistor and then, in the second step the impurities of the regions of the P-channel field-effect transistor are introduced into the semiconductor surface before being activated, characterized in

that after the gate oxidation process, the semiconductor surface is exposed in the area (10) of the emitter region and in the area (11) of the collector contact region of the bipolar transistor ;

that impurities of the conductivity type of the substrate are implanted into the exposed semiconductor surface of the emitter region area (10) and of an adjacent portion below the thin oxide layer (9) of the bipolar transistor using a mask against implanted ions ;

that unwanted portions of the n-type electrode material layer deposited on the semiconductor surface are then etched away to form the gate electrodes (16, 17) of the field-effect transistors, the emitter electrode (19) of the bipolar transistor, and the collector electrode (18) of the bipolar transistor ;

that then, during the masked implantation process for introducing the impurities of the regions of the P-channel field-effect transistor, the impurities of a base contact region (21) are introduced into the semiconductor surface between the emitter electrode (19) and the collector electrode (18), and

that a high-temperature process is finally used in which the implanted ions are activated and in which the emitter region (23) and the collector contact region (22) are diffused from the emitter electrode (19) and the collector electrode (18), respectively.

2. A method as claimed in claim 1, characterized in that an opening (6) in the area of the substrate region (2) of the bipolar transistor is filled by the emitter area (10), the collector contact area (11), and a stripelike thin oxide layer (9) which is disposed between these two areas and divides the opening (6).

3. A method as claimed in claim 1 or 2, characterized in that the opening (6) is rectangular.

4. A method as claimed in any one of claims 1 to 3, characterized in that the opening (6) is divided by a stripelike thin oxide layer (9) which, bordering on the collector electrode (18) along the entire length of the edge, is overlapped by this electrode.

5. A method as claimed in any one of claims 1 to 4, characterized in that the openings (4, 5) of the field-effect transistors in the thick oxide layer (10) are each divided by a stripelike oxide layer (13) which is used as a gate oxide layer.

**Revendications**

1. Procédé de fabrication d'un circuit intégré monolithique comprenant au moins une paire de transistors à effet de champ complémentaire dont les électrodes de grille sont en matériau de type N et au moins un transistor planar bipolaire de type NPN, dans lequel,

dans une face d'une tranche de type P utilisée comme substrat (1), une première région de substrat (2) et une seconde région de substrat (3) sont respectivement formées pour le transistor bipolaire NPN et le transistor à effet de champ à canal P ;

la surface exposée est ensuite pourvue d'une couche d'oxyde épais (15) dans laquelle des ouvertures (4, 5, 6) sont formées, dans les zones des régions de substrat (2, 3) et du transistor à effet de champ à canal N, qui sont refermées par des couches d'oxyde mince (7, 8, 9) au cours du processus d'oxydation de grille ;

en utilisant un masque d'implantation, des impuretés du type de conductibilité du substrat sont ensuite implantées à travers des parties de la couche d'oxyde mince (9) du transistor bipolaire avec une tension d'accélération suffisante pour traverser cette couche d'oxyde mince (9) ;

une couche de matériau d'électrode de type N est ensuite déposée sur cette face, dont les électrodes de grilles (16, 17) des transistors à effet de champ et l'électrode d'émetteur (19) du transistor bipolaire sont obtenues par attaque chimique, et

dans deux étapes d'implantation ionique masquée, après exposition de la surface du semi-conducteur, en dehors des électrodes de grilles (16, 17), d'abord les impuretés des régions du transistor à effet de champ à canal N et, ensuite, dans une seconde étape, les impuretés des régions du transistor à effet de champ à canal P sont introduites dans la surface du semi-conducteur, avant d'être activées, caractérisé en ce que,

après le processus d'oxydation de grille, la surface du semi-conducteur est exposée dans la zone (10) de la région d'émetteur et dans la zone (11) de la région de contact de collecteur du transistor bipolaire ;

des impuretés du type de conductibilité du substrat sont implantées dans la surface exposée du semi-conducteur de la zone de la région d'émetteur (10) et d'une partie adjacente en dessous de la couche d'oxyde mince (9) du transistor bipolaire, en utilisant un masque d'implantation ionique ;

de la couche de matériau d'électrodes de type N déposée sur la surface du semi-conducteur sont obtenues par attaque chimique, les électrodes de grille (16, 17) des transistors à effet de champ, l'électrode d'émetteur (19) du transistor bipolaire et l'électrode de collecteur (18) du transistor bipolaire ;

ensuite, durant le processus d'implantation ionique masquée des régions du transistor à effet de champ à canal P, les impuretés de la région de contact de base (21) sont introduites dans la surface du semi-conducteur entre les électrodes d'émetteur (19) et de collecteur (18) ; et

un processus à haute température est finalement utilisé, par lequel les ions implantés sont activés et par lequel la région d'émetteur (23) et la région de contact de collecteur (22) sont respectivement diffusées à partir de l'électrode d'émetteur (19) et de l'électrode de collecteur (18).

2. Procédé selon la revendication 1, caractérisée en ce que l'ouverture (6) dans la zone de la région de substrat (2) du transistor bipolaire est remplie par la zone d'émetteur (10), la zone de contact de collecteur (11) et une couche d'oxyde mince en forme de bande (9) qui est disposée entre ces deux zones et divise l'ouverture (6).

3. Procédé selon la revendication 1 ou 2, caractérisée en ce que l'ouverture (6) est rectangulaire.

4. Procédé selon l'une quelconque des revendications 1 à 3, caractérisé en ce que l'ouverture (6) est divisée par une couche d'oxyde mince (9) en forme de bande qui, délimitant l'électrode de collecteur 10 (18) sur toute la longueur de son côté, est recouverte par cette électrode.

5. Procédé selon l'une quelconque des revendications 1 à 4, caractérisé en ce que les ouvertures (4, 5) des transistors à effet de champ dans la couche d'oxyde épais (10) sont chacune divisée par une couche d'oxyde en forme de bande (13) qui est utilisée comme couche d'oxyde de grille.

FIG. 1

NMOS          PMOS          NPN

FIG. 2

FIG. 3

FIG. 4

# 0 080 523

**FIG. 5**

**FIG. 6**

**FIG. 7**

**FIG. 8**